## Europäisches Patentamt

## European Patent Office

## Office européen des brevets

(19)

(11) Publication number: **0 230 304**
A2

(12) **EUROPEAN PATENT APPLICATION**

(21) Application number: **87100696.1**

(22) Date of filing: **20.01.87**

(51) Int. Cl.⁴: **G 11 C 15/00**

(30) Priority: **21.01.86 US 820349**

(43) Date of publication of application: **29.07.87**
**Bulletin 87/31**

(84) Designated Contracting States: **AT BE CH DE ES FR GB GR IT LI LU NL SE**

(71) Applicant: **ENERGY CONVERSION DEVICES, INC.,**
**1675 West Maple Road, Troy Michigan 48084 (US)**

(72) Inventor: **Johnson, Robert R., 25885 German Mill Road, Franklin Michigan 48025 (US)**
Inventor: **Pryor, Roger W., 4918 Malibu, Bloomfield Hills Michigan 48013 (US)**
Inventor: **Wicker, Guy C., 564 South Boulevard, Rochester Hills Michigan 48063 (US)**

(74) Representative: **Müller, Hans-Jürgen, Dipl.-Ing. et al, Müller, Schupfner & Gauger Lucile-Grahn-Strasse 38 Postfach 80 13 69, D-8000 München 80 (DE)**

(54) **Content adressable memory.**

(57) A content addressable memory includes a memory cell (36) connected at each crossover point between rows (32) and columns (34, 36) of conductors to define first (26) and second (28) arrays of memory cells wherein the data stored in the second array includes the complement of that stored in the first array. In an associative mode of operation, an input code is applied simultaneously to all of the columns of the first and second arrays of memory cells. The existence of a match between the input code and a key forming a part of a stored data word is recorded as logical states on the rows of conductors which indicate the location in memory of the data word in which a match is achieved. In a conventional RAM mode of operation, data can be written (16b) into or read (16a) from the first memory array.

## CONTENT ADDRESSABLE MEMORY

## TECHNICAL FIELD

The present invention broadly relates to memory devices, and deals more particularly with a content addressable memory in which an input code is compared to data contained in at least one key in one or more stored words to determine the storage location of words having data in the key that match the input code.

## BACKGROUND ART

In retrieving data from memories, it is often necessary or desirable to address certain memory locations which contain data of a particular type. In a conventional RAM (random access memory), if the storage location of a particular type of data is not known, it is necessary to sequentially address each data entry or word in order to locate the entry

-2-

containing the information type being sought. This sequential addressing is normally performed by software and is rather inefficient in that valuable processing time is wasted in address and examining data entries that do not contain the specific information being sought.

In order to eliminate the above-mentioned problem, content addressable memories have been proposed which permit rapid addressing and read-out of only those data entries containing the specific information of the type sought. Content addressable memories are random access memory devices which provide read and write functions as well as an "associative" function. For use in association, part of each word stored in the memory array is a code that is employed as a key. During an associative operation, the content addressable memory (CAM) automatically compares an input code to the key of each word. For each word where the key matches, an output signal is produced to indicate that a match condition has occurred. The position of the output signal reveals the storage locations which contain words that match the key. After the storage locations of the words that match the key have been determined, normal read or write operations can be performed to these addresses. In some applications, the complete data word or field is used as the key, instead of a few bits thereof.

Conventional CAMs are typically produced using bipolar technology, in which each memory cell comprises a relatively large number of logic elements. Because of the relatively large number of logic elements contained in each CAM cell, previous CAMs have not gained widespread use because of their high cost of production and their small size.

0230304

-3-

Moreover, the relatively large amount of hardware logic required to implement previous CAMs requires a relatively large area on a substrate, using conventional crystalline silicon-based technology. Additionally, the relatively large number of logic devices required for each memory cell reduces the production yield and reliability of these prior devices.

It would therefore be desirable to provide a CAM having a much simplified form of memory cell which could be more economically manufactured and which could have much greater cell density than has been heretofore been possible. It would also be desirable to reduce the amount of hardware-based or software-based logic required to implement a content addressable memory system. The present invention is intended to satisfy these and further objects.

## SUMMARY OF THE INVENTION

In accordance with one aspect of the present invention, a content addressable memory is provided which substantially reduces production costs, achieves a higher memory cell density and decreases data processing time. The memory broadly includes first and second arrays of programmable memory cells for respectively storing first and second sets of data, in which the second set of data includes the complement of the first set thereof. The memory cells in each of the arrays are arranged in N rows of M columns wherein at least certain of the data stored in each row of cells is arranged in preselected fields defining a key. Each memory cell includes a programmable device which is settable in either a conductive or non-conductive state. In one embodiment, the programmable device comprises a phase changeable

0230304

-4-

material defined by an amorphous silicon alloy or a chalcogenide. Each of the memory cells further includes a selection device in the nature of a diode for selecting the cell from the other cells in the array. Input code means are provided for simultaneously applying first and second sets of input signals respectively to all of the memory cells in the first and second arrays. The first and second sets of input signals represent an input code which corresponds to a preselected type of data, and which matches the data in a key of at least one of the rows of the memory cells in either the first or second array. Output means coupled with the first and second arrays are provided for obtaining match signals from at least one row of cells in the arrays. The match signals represent the locations in the first array of a match between the input code and the data in a key at that locations. The memory cells are connected between rows and columns of conductors at the crossover points of the conductors. Means are provided for addressing the data words which have data in keys matching the input code and for reading out the data words addressed by the addressing means. The memory cells may be produced using vertical integration techniques to achieve exceptionally high cell densities.

According to another aspect of the present invention, a method is provided for processing data in a mass data storage device which comprises the steps of storing a first set of data, storing a second set of data which includes the complement of said first set of data, and determining the location of a certain type of data in said first set of data by operating on said first and second sets of data. The operating step is performed by obtaining a match between a code

-5-

and data in preselected fields in the first and second sets of data.

## BRIEF DESCRIPTION OF THE DRAWINGS

In the drawings, which form an integral part of the specification and are to be read in conjunction therewith, and in which like reference numerals are employed to designate identical components in the various views:

Figure 1 is a block diagram of a content addressable memory according to the preferred embodiment of the present invention;

Figure 2 is a diagrammatic view showing how the storage locations of the memory of Figure 1 are arranged and depicting a typical example of the type of data stored in the memory.

Figures 3A and 3B, taken together, form a combined block and detailed schematic diagram of the memory shown in Figure 1;

Figure 4 is a truth table of the signals applied to the primary and complementary memory arrays which represent the match field; and,

Figure 5 is a schematic diagram of an individual memory cell.

## DESCRIPTION OF THE PREFERRED EMBODIMENT

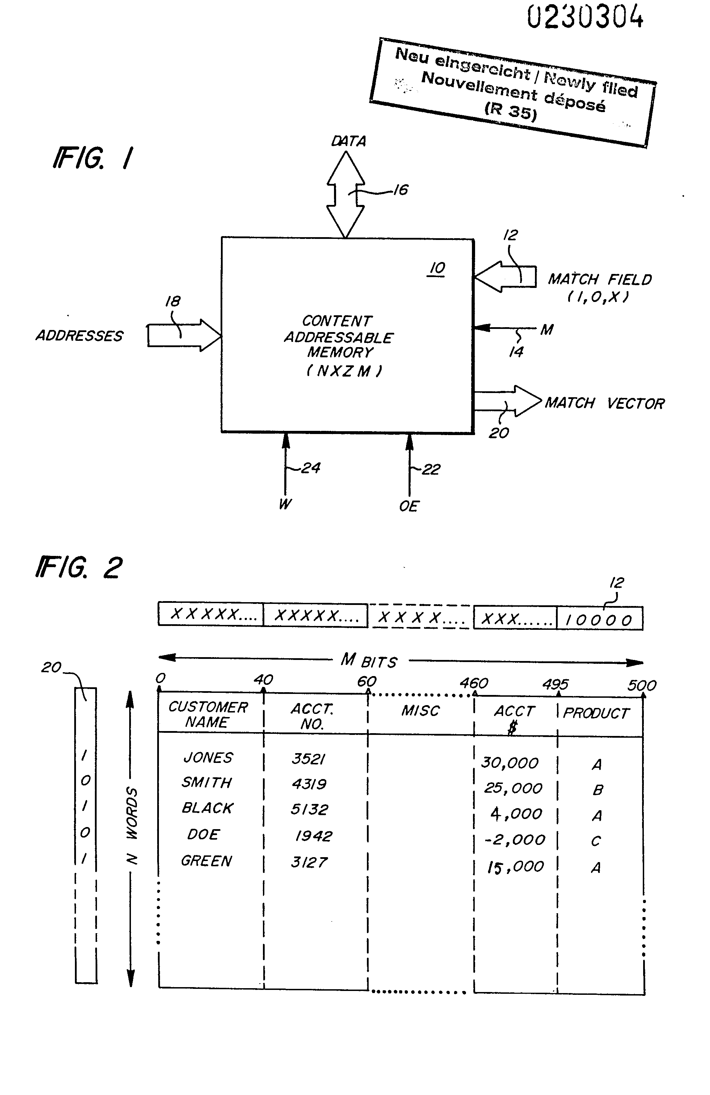

Referring first to Figure 1, the content addressable memory 10 of the present invention comprises an N x 2M array of later-discussed memory cells which may be addressed using address lines 18. A bi-directional data bus 16 allows data to be written into or read from the memory cells. An operation enable (OE) line 22 enables operation of the memory 10

-6-

and a write line 24 (W) controls whether data is being written into or read from the memory.

The memory further includes a match field input 12 which consists of a plurality of input lines which convey the logical states of "1", "0" or "X" (don't care). These logical states are simultaneously input to the memory 10 as a "field", and as will become later apparent, are employed to address certain fields in the memory 10 which include an encoded key. A mode select line 14 (M) determines whether the match field 12 addresses the memory or whether the conventional addresses 18 are employed to address the memory.

In the event that the match field 12 is employed to address the memory 10, those memory locations having data in a coded key which matches the match field 12 results in a match. The matches are represented by logical 1's or 0's which appear on a plurality of output lines 10 as a match vector. The match vector provides an indication of the location of words in the memory 10 where a match occurs between the match field 12 and the data in the coded key of a stored data word. The mode of operation described immediately above in which the memory 10 is addressed by the match field 12 in order to obtain a match vector 20 is referred to as an "associative mode" of operation. Having obtained the match vector 20, and thus the locations of the data words in which a match has occurred, it is then possible to address the "matched" data words using the address lines 18, whereupon these data words may be read out on the data lines 16 in a conventional manner. This latter mode of operation in which the data words are read from memory is referred to as a normal read mode of operation. In a similar manner, the memory 10 may be used in a normal write mode to write data into memory.

-7-

Attention is now directed to Figure 2 which provides an illustration of the manner in which half (N x M) of the N x 2M memory 10 may be arranged to store data relating to customer files. The N x M memory 10a is arranged in a column of N words, each M bits long. For illustrative purposes, each of the words are 500 bits long and are arranged in fields corresponding to the customer's name, the customer's account number, miscellaneous data relating to the customer, the amount of money in the account and the type of product sold to the customer. The product types are represented by the letters A, B and C in this particular example. Assume now that it is desired to know which of the customer's product A is being sold to; in that event, a match field 12 is applied to the memory 10a in which all but the product field is designated as "X" (don't care) and in which the produce field is encoded with an input code. In the present example, the binary designation of 10000 is employed to indicate produce A. As will be later apparent, upon applying the match field 12 to the memory 10a, and to a corresponding complementary memory (not shown in Figure 1) the data words or customer entries having produce A in the product field will result in a match between the data in the product field and the match field 12. Scanning the contents of the memory 10a an the complementary memory with the match field 12 shown in Figure 2 results in a match vector 20 shown adjacent the left side of the memory 10 in Figure 2, which consists of 10101; this vector reveals the location in memory of those entries in which a match occurs. In other words, product A is sold to Jones, Black and Green, consequently the logical state of the match vector output lines associated with these customers are logical 1's while the match vector output lines for Smith and Doe are

0230304

-8-

logical 0's. It may thus be readily appreciated that employment of the match field 12 provides a rapid means for identifying those customer entries or data words which include the data of interest, without the necessity of successively reading out and examining each line (word) from memory to determine whether a match exists.

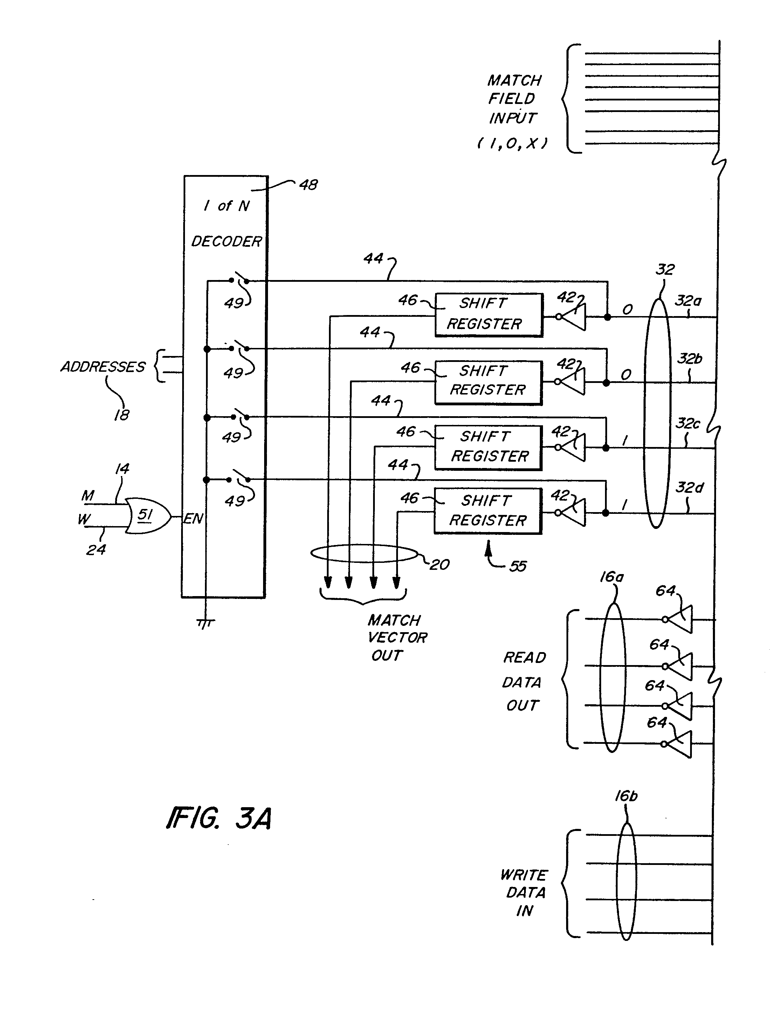

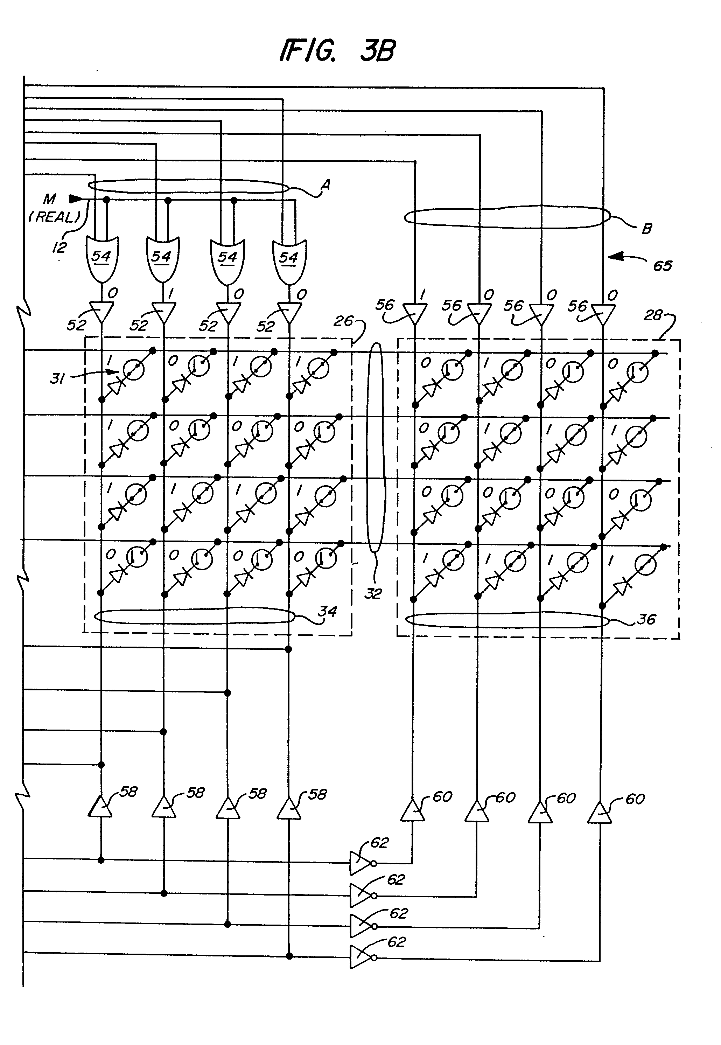

The memory 10 of the present invention is depicted in more detail in Figure 3, and broadly comprises first and second N x M arrays 26, 28 of memory cell circuits, one of such circuits being generally indicated by the numeral 30. For purposes of the present description, array 26 will be referred to as the "primary" array while array 28 will be referred to as the "complementary" array. This nomenclature is employed because, as will be described below, the data stored in the complementary array 28 includes the complement or inverse of that stored in array 26.

The memory 10 further includes a first set of conductors 32 extending in the X direction and forming rows, as well as second and third sets of conductors 34 and 36 which extend in the Y direction and form the columns. The X conductors 32 extend orthogonally or transverse to both sets of Y conductors 34, 36 and thus form crossover points. These X and Y conductors 32 and 34, 36 are insulated from each other but are selectively electrically connected with each other adjacent the crossover points by the memory circuits 30.

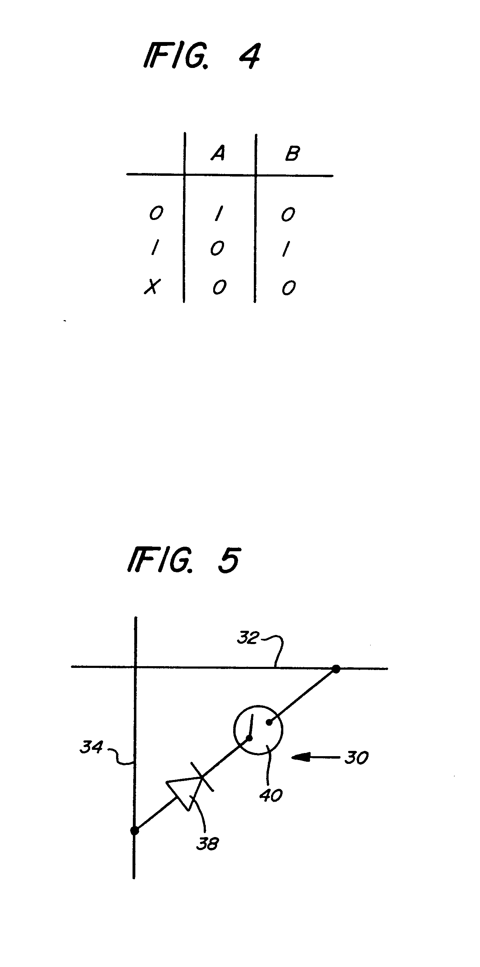

Reference is now made temporarily to Figure 5 which depicts one of the memory circuits 30 in more detail. The circuit 30 is a series circuit which is connected between the X and Y conductors adjacent the crossover point. Each of the memory circuits 30 includes a selection device in the nature of a diode

-9-

38 and a programmable switch device 40 which is settable in either a conductive or non-conductive state. By way of example, a reversible phase changeable material defined by either an amorphous semiconductor alloy which will be described later in more detail, or a chalcogenide material. The conductive state of the device 40 employing the phase changeable material may be altered by applying thereto an electrical current of sufficient threshold which, by way of example, may be typically one to ten milliamps applied for a duration between 1 microsecond to 1 millisecond. In its conductive state, the device 40 functions as a sensor to allow passage therethrough of current between the X and Y conductors 32, 34, typically on the order of 500 microamps or less for periods on the order of several nanoseconds. It may thus be appreciated that each memory circuit or cell 30, by virtue of the interconnection between the X and Y conductors at the crossover points, functions to supply either a 1 or 0 when addressed, thus effectively providing one bit of data storage.

The memory cell arrays 26, 28 are preferably formed in a single matrix construction in which the X and Y conductors 32, 34, 36 and each memory circuit 30 are formed in a vertically integrated structure on a substrate. By using vertical integration, extremely high packaging densities may be achieved, thus reducing the amount of physical space occupied by the memory 10. One method for making a continuous matrix array of the type described above is disclosed in U.S. Patent No. 4,545,111, issued October 8, 1985, for Method For Making, Parallel Preprogramming or Field Programming of Electronic Matrix Arrays, the entire disclosure of which is incorporated herein by reference. Briefly, the integrated structure is produced by first forming one set of the conductors on

-10-

an insulative substrate such as glass. Layers of p-type, intrinsic and n-type semiconductor layers are then successively deposited over the first set of conductors to form the diodes. A thin layer of metal is applied over the top layer of the diode material, following which a layer of phase changeable material such as an amorphous silicon alloy or chalcogenide is applied over the metal. The second set of conductors are then applied over the phase change material to form a composite, vertically sandwiched construction. The p-i-n diode structure may be formed from amorphous silicon alloy which can advantageously be deposited in multiple layers over large area substrates to form such structures in high volume, continuous processing systems.

Returning now to Figure 3, each of the arrays 26, 28 is depicted as a 4 x 4 matrix in order to simplify the present description, however it is to be understood that in actual practice, either or both of these arrays may be defined by a very large number (one million or more) of the memory cells 30. Moreover, the arrays 26, 28 need not be equal in terms of the numbers of rows or columns of memory cells 30. For illustrative purposes, array 26 is depicted as having been programmed with the following data words: 1011, 1000, 1111, and 0000. Since array 28 is the complement of array 26, the following words have been programmed into array 28: 0100, 0111, 0000, 1111. Memory cells 30 which have been programmed to be 0's are shown as having open switches 40 (circuits), whereas those programmed with a "1" are shown as having closed switches 40 which form a short circuit between crossing conductors 32, 34, 36. For further convenience, the logical state of each cell 30 is indicated near each crossover point in each array 26, 28.

-11-

The X conductors 32 are respectively connected through inverters 42 to corresponding registers 46.  The inverters 42 function to sense the logical states of the corresponding conductors 32, and the inverted output of inverters 42 are stored in registers 46.  Thus, for example, if one of the memory cells 30 in a row thereof is conducting current between X and Y conductors, the corresponding conductors 32 is high and a logical 0 is stored in the corresponding register 46.  On the other hand, if none of the memory cells 30 of a row in both arrays 26 or 28 is conducting, the conductor 32 will be low and a logical 1 is stored in the corresponding register 46. The outputs of the registers 46 form the match vector lines 20.  As previously indicated, the logical states of lines 20 indicate the locations of matches between the input code and data contained in the corresponding keys of the data words stored in the arrays 26, 28.

A 1 of N decoder 48 has output lines 44 respectively connected to the X conductors 32 to permit addressing of the memory cells 30 in both arrays 26 and 28.  The decoder 48 effectively grounds the output lines 44 by means of switches 49 in accordance with the logical states of its input address lines 18.  The decoder 48 has an enable input to enable the decoder 48 in response to either an M or W signal gated through OR gate 51; thus, the decoder 48 is enabled when the memory 10 is operating in either a normal read or write mode.  The conductors 32 along with inverters 42, registers 46 and lines 20 form output means generally indicated by the numeral 55 for obtaining and outputting match signals from the memory circuits 30 in each row thereof.

The Y conductors 34 of the primary array 26 are connected through inverters 64 to read data lines 16a which provide data read out of the primary array

-12-

26. Data is written into the memory cells 30 of arrays 26 and 28 by means of write data lines 16b. The input write signals are delivered through current drivers 58 which provide sufficient current to alter the conductive state of the programmable devices 40 of the memory cells 30 in the primary array 26. The input write signals are inverted by inverters 62 and are likewise delivered through drivers 60 which function to alter the conductivity of the programmable devices 40 of the memory cells in the complementary array 28.

Input code means generally indicated by the numeral 65 is provided for simultaneously applying first and second sets of input code signals respectively to all of the memory cells 30 in the first and second arrays 26, 28. The input code corresponds to a preselected type of data which may be found in any of the keys of the data words stored in the memory 10. The input code means 65 includes first and second sets of data lines respectively designated by the letters A and B. The signals applied to lines A and B define an input code, as previously mentioned, and may be supplied by the data processing system or computer which incorporates the present memory 10. Lines A form inputs to corresponding OR gates 54, a second set of inputs to the OR gates 54 being formed by the read line 12(M). The outputs of OR gates 54 are delivered through current drivers 52 which provide a sufficient level of current to sense whether any of the programmable devices 40 are closed (conductive), however the energy of these signals is not sufficient to reset any of the devices 40. The signals on lines B are likewise delivered to drivers 56 which provide sensing current to the conductors 36 in the complementary array 28.

-13-

Input code means generally indicated by the numeral 65 is provided for simultaneously applying first and second sets of input code signals respectively to all of the memory cells 30 in the first and second arrays 26, 28. The input code corresponds to a preselected type of data which may be found in any of the keys of the data words stored in the memory 10. The input code means 65 includes first and second sets of data lines respectively designated by the letters A and B. The signals applies to lines A and B define an input code, as previously mentioned, and may be supplied by the data processing system or computer which incorporates the present memory 10. Lines A form inputs to corresponding OR gates 54, a second set of inputs to the OR gates 54 being formed by the read line 12(M). The outputs of OR gates 54 are delivered through current drivers 52 which provide a sufficient level of current to sense whether any of the programmable devices 40 are closed (conductive), however the energy of these signals is not sufficient to reset any of the devices 40. The signals on lines B are likewise delivered to drivers 56 which provide sensing current to the conductors 36 in the complementary array 28. A truth table relating the logical states of lines A and B with the possible entries in the match field is depicted in Figure 4.

Having described the constituent components of the memory 10, an explanation of its various modes of operation will now be provided. In the normal write mode, all of the lines A and B are 0's, line 14 is low and the write line 24 is high, thereby enabling the decoder 48. Data is written into the memory arrays 26, 28 on write lines 16b. The decoder 48 functions to ground the appropriate X conductor 32 in order to allow a resetting level of current to pass

-14-

through the programmable switches 40 of the addressed
row. As previously mentioned, the inverters 62 invert
the data written into array 28 so that this
latter-mentioned data forms the complement of that
stored in array 26.

In the normal read mode, line 14 is high,
write line 24 is low and lines A and B are also low.
The high signal on line 14 is gated through OR gate 51
to enable the decoder 48. The decoder 48 again
grounds the conductors 32 corresponding to the rows of
the array 26 which are to be read out. The data in
array 26 is read out on conductors 34 and read lines
16a.

In the associative mode, lines 14 and 24 are
low, consequently the decoder 48 is disabled. Match
field input signals are input on lines A and B
respectively to the arrays 26 and 28. As previously
discussed, these two sets of input signals correspond
to an input code which potentially matches the data in
at least one key in one of the words stored in either
the primary array 26 or the complementary array 28.
For illustrative purposes, assume that the match field
input code is 10XX; thus, the first and second columns
of memory cells 30 in both arrays 26 and 28 form the
fields which will be searched for a match with the
input code. Referring to the truth table shown in
Figure 4, it can be seen that the signals applied to
lines A and thus to the array 26, is 0100 while the
signals applied to lines B and array 28 is 1000.
Observe now that only the first two words in array 26
have a key (10XX) which corresponds to the input code;
thus, the match vector output on lines 20 should be
1100. Note that the match field input signals which
are 0 will not result in sensing current passing
through a memory cell 30 even if the switch 40 of that
cell 30 is closed, consequently the match field input

-15-

signals which are 0's can be ignored in the present analysis. The match field inputs which are logical 1's, namely those in column 2 of array 26 and column 1 of array 28, do not result in sensing current passing through the corresponding memory cells 30 in the first word, accordingly, line 32a remains low. For these reasons, line 32b is also low.

With respect to the fourth word in the primary array, it can be seen that the match field input of logical 1 in the second column results in current flow through the corresponding memory cell in the third row, consequently line 32c goes high. Finally, observe carefully that in the case of the fourth word in the primary array 26, the programmable switch 40 in the second column is open, consequently it is not possible to pass current through the corresponding memory cell even though the match field input to this cell is high. Since the complementary array 28 contains the complement of the data stored in array 26, all of the switches 40 in the last row of memory cells 30 in array 28 are closed; consequently, the logical 1 defining the first bit of the match field input on line B results in current flowing through the first memory cell 30 of the fourth row and accordingly, line 32d goes high. Based on the above, it may thus be appreciated that, in the absence of the complementary array 28, a false match would be indicated with respect to the fourth word.

From the foregoing analysis, it can be see that lines 32a-32d respectively have the logic states 0011. These logic states are inverted by inverters 42 and the resultant match vector of 1100 is stored in registers 46 for subsequent delivery on the match vector lines 20.

From the above description, it can be appreciated that the present invention provides a

-16-

novel method of processing data in a mass data storage device. The method broadly includes the steps of storing a first set of data, storing a second set of data which includes the complement of the first set of data, and determining the location of selected data in said first set of data by operations on said first and second sets of data. The operating step is carried out by obtaining a match between a code and data contained in preselected fields in the first and second sets of data.

Having thus described the invention, it is recognized that those skilled in the art may make various modifications and additions to the preferred embodiment chosen to illustrate the invention without departing from the spirit and scope of the present contribution to the art. Accordingly, it is to be understood that the protection sought and to be afforded hereby shall be deemed to extend to the subject matter claimed and all equivalents thereof fairly within the scope of the invention.

-17-

We Claim:

1.  A content addressable memory device, comprising:

first means (26) for storing a first set of first data words therein, at least certain of the data in at least one of the first data words being arranged in at least one preselected field defining a first key;

second means (28) for storing a second set of second data words containing the complement of said first set of first data words, at least certain of the data in at least one of the second data words being arranged in at least one preselected field defining a second key;

third means (12) for supplying a code corresponding to a preselected pattern of data desired to be located among the data within said first and second keys; and,

fourth means (20) for obtaining at least one match signal indicating that one of said first data words or one of said second data words contains data in its respective key corresponding to said code.

2.  The memory of claim 1, wherein said first and second means each includes an array of memory cells (30), said memory cells including a programmable device (40) settable between a relatively conductive state or a relatively non-conductive state.

3.  The memory of claim 2, wherein said programmable device is resettable and includes a phase changeable material selected from the group consisting of an amorphous silicon alloy and a chalcogenide.

4.  The memory of claim 2, wherein the memory cells in the arrays of said first and second means are interconnected by common conductors (32,34,36).

5.  The memory of claim 1, wherein said fourth means includes means for storing said match

0230304

-18-

signal.

6. The memory of claim 1, including fifth means (16a) for addressing the data words in said first and second storing means and sixth means (16b) for reading out data words stored in said first storing means.

7. A method of determining the address locations of certain words of a group of data words stored in a memory wherein each of the data words includes a selected data field defining a key, comprising the steps of:

(A) forming the complement of the data in said data words;

(B) comparing the data in the key of each data word with a code representing a desired set of data to determine whether a match exists therebetween;

(C) comparing the complement of the data in the key to determine whether a match exists therebetween;

(D) producing a match signal when a match is obtained in step (B) or step (C).

# FIG. 1

DATA — 16

CONTENT ADDRESSABLE MEMORY ( NXZM ) — 10

MATCH FIELD ( 1,0,X ) — 12

ADDRESSES — 18

M — 14

MATCH VECTOR — 20

W — 24

OE — 22

# FIG. 2

| X X X X X.... | X X X X X.... | X X X X.... | X X X...... | I 0 0 0 0 | — 12 |

20 — | 1 0 1 0 1 |

M BITS

N WORDS

| | CUSTOMER NAME | ACCT. NO. | MISC | ACCT $ | PRODUCT |
|---|---|---|---|---|---|
| 0 | 40 | 60 | | 460 | 495 | 500 |
| | JONES | 3521 | | 30,000 | A |
| | SMITH | 4319 | | 25,000 | B |
| | BLACK | 5132 | | 4,000 | A |
| | DOE | 1942 | | -2,000 | C |
| | GREEN | 3127 | | 15,000 | A |

FIG. 3A

FIG. 3B

## FIG. 4

|   | A | B |
|---|---|---|
| 0 | 1 | 0 |
| 1 | 0 | 1 |
| X | 0 | 0 |

## FIG. 5